# EUROPÄISCHE PATENTSCHRIFT

(11) **EP 2 979 102 B1**
(45) Veröffentlichungstag und Bekanntmachung des Hinweises auf die Patenterteilung: **12.06.2019**
(21) Anmeldenummer: 14708838.9
(22) Anmeldetag: 03.03.2014
(51) Int. Cl.: G01R 33/07

(54) **FREMDMAGNETFELD-UNEMPFINDLICHER HALLSENSOR**
HALL SENSOR INSENSITIVE TO EXTERNAL MAGNETIC FIELDS
CAPTEUR À EFFET HALL INSENSIBLE AUX CHAMPS MAGNÉTIQUES EXTÉRIEURS

(30) Priorität: 26.03.2013 DE 102013205313
(43) Veröffentlichungstag der Anmeldung: 03.02.2016
(73) Patentinhaber: Robert Bosch GmbH, 70442 Stuttgart (DE)
(72) Erfinder: LANG, Norbert, 71735 Eberdingen (DE); MAESS, Johannes, 70563 Stuttgart (DE); BOEHRINGER, Thomas, 75428 Illingen (DE); SANDMANN, Frank, 71665 Vaihingen (DE); KLOTZBUECHER, Thomas, 73635 Rudersberg (DE)
(86) Internationale Anmeldenummer: PCT/EP2014/054078
(87) Internationale Veröffentlichungsnummer: WO 2014/154446

(56) Entgegenhaltungen:
- BANJEVIC M ET AL: "2D CMOS integrated magnetometer based on the miniaturized circular vertical Hall device", SOLID-STATE SENSORS, ACTUATORS AND MICROSYSTEMS CONFERENCE, 2009. TRANSDUCERS 2009. INTERNATIONAL, IEEE, PISCATAWAY, NJ, USA, 21. Juni 2009 (2009-06-21), Seiten 877-880, XP031545768, ISBN: 978-1-4244-4190-7
- KEJIK P ET AL: "Circular Hall Transducer for Angular Position Sensing", SOLID-STATE SENSORS, ACTUATORS AND MICROSYSTEMS CONFERENCE, 2007. TRANSDUCERS 2007. INTERNATIONAL, IEEE, PISCATAWAY, NJ, USA, 10. Juni 2007 (2007-06-10), Seiten 2593-2596, XP031216602, ISBN: 978-1-4244-0841-2

## Beschreibung

### Stand der Technik

Hallsensoren werden in vielen Bereichen der Technik eingesetzt. Beispielsweise können Hallsensoren verwendet werden, um Drehbewegungen und insbesondere Drehwinkel berührungslos zu detektieren.

Das Messsignal von Hallsensoren ist abhängig von einem Magnetfeld. Daher sind Hallsensoren in der Regel empfindlich gegenüber Störfeldern, die z.B. durch stromführende Leitungen oder Magnete in der Umgebung des Hallsensors verursacht werden können. Beispielsweise kann ein Störfeld an einem Hallsensor zu verfälschten Winkelmesswerten führen.

BANJEVIC M ET AL: "2D CMOS integrated magnetometer based on the miniaturized circular vertical Hall device",SOLID-STATE SENSORS, ACTUATORS AND MICROSYSTEMS CONFERENCE, 2009. TRANSDUCERS 2009. INTERNATIONAL, IEEE, PISCATAWAY, NJ, USA, 21. Juni 2009 (2009-06-21), Seiten 877-880, XP031545768,ISBN: 978-1-4244-4190-7 und KEJIK P ET AL: "Circular Hall Transducer for Angular Position Sensing",SOLID-STATE SENSORS, ACTUATORS AND MICROSYSTEMS CONFERENCE, 2007. TRANSDUCERS 2007. INTERNATIONAL, IEEE, PISCATAWAY, NJ, USA, 10. Juni 2007 (2007-06-10), Seiten 2593-2596, XP031216602,ISBN: 978-1-4244-0841-2 offenbaren auch Hall-Sensoren in kreisförmiger Anordnung und Spinning current Offset-Kompensierung. Die Hall-Sensoren sind aber vertikale Hall-Sensoren und sind als Circular Vertical Hall-Sensoren gekoppelt. Eine Offset-Kompensierung erfolgt jeweils sequentiell und pro Paar.

### Offenbarung der Erfindung

Es kann daher ein Bedarf an einem verbesserten Hallsensor und einem verbesserten Herstellungsverfahren für einen Hallsensor bestehen, die insbesondere eine geringere Empfindlichkeit der Sensorsmesswerte gegenüber Störfeldern gewährleisten.

Dieser Bedarf kann durch den Gegenstand der vorliegenden Erfindung gemäß den unabhängigen Ansprüchen gedeckt werden. Vorteilhafte Ausführungsformen der vorliegenden Erfindung sind in den abhängigen Ansprüchen beschrieben.

Im Folgenden werden Merkmale, Einzelheiten und mögliche Vorteile einer Vorrichtung gemäß Ausführungsformen der Erfindung im Detail diskutiert.

Gemäß einem ersten Aspekt der Erfindung wird ein Hallsensor vorgestellt. Der Hallsensor weist ein erstes Hallelement-Paar auf, das ausgeführt ist, ein erstes Messsignal bereitzustellen. Ferner weist der Hallsensor ein zweites Hallelement-Paar auf, das ausgeführt ist, ein zweites Messsignal bereitzustellen. Des Weiteren weist das Hallelement mindestens ein weiteres Hallelement-Paar auf, dieses wird als drittes Hallelement-Paar bezeichnet. Das dritte Hallelement-Paar ist ausgeführt, ein drittes Messsignal bereitzustellen. Die Hallelemente des dritten Hallelement-Paars sind dabei jeweils zwischen Hallelementen des ersten Hallelement-Paars und des zweiten Hallelement-Paars angeordnet. Die Hallelement-Paare sind derart ansteuerbar, dass das erste Messsignal, das zweite Messsignal und das dritte Messsignal zu einem Gesamtmesssignal kombinierbar sind, welches einen durch ein Fremdmagnetfeld verursachten Fehler berücksichtigt.

Anders ausgedrückt basiert die Idee der vorliegenden Erfindung darauf, im Vergleich zu bekannten Ausführungen mit zwei Hallelement-Paaren, mindestens ein weiteres Hallelement-Paar vorzusehen und dessen Messdaten in Kombination mit den anderen zwei Messsignalen dazu zu verwenden, einen durch ein Fremdmagnetfeld verursachten Fehler herauszurechnen. Dabei sind die Hallelement-Paare winkelversetzt zueinander angeordnet, so dass durch Vergleich der einzelnen Messwerte z.B. ein stationäres bzw. statisches Fremdmagnetfeld von einem Feld eines dem Hallsensor zur Winkelmessung zugeordneten rotierenden Magneten unterschieden werden kann.

Durch die Ausgestaltung des Hallsensors mit zusätzlichen Hallelement-Paaren kann die Berechnung des Gesamtmesssignals unempfindlicher gegenüber Fremdmagnetfeldern ausgeführt werden. Ferner sind die erfindungsgemäßen Hallsensoren gegenüber bekannten Sensoren nicht mit Mehrkosten verbunden.

Beispielsweise können die erfindungsgemäßen Hallsensoren in der Fahrzeugtechnologie zum Einsatz kommen. Insbesondere, können diese verbesserten Hallsensoren in Hybridfahrzeugen und in Elektrofahrzeugen vorteilhaft genutzt werden. Da in Hybrid- und Elektrofahrzeugen viele stromführende Leitungen, Permanentmagneten, Elektromagneten und Leistungselektroniken vorgesehen sind, kann es zu Wechselwirkungen zwischen dem Hallsensor und diesen Elementen kommen. Der erfindungsgemäße Hallsensor berücksichtigt diese Wechselwirkungen und kompensiert sie bei der Berechnung des Gesamtmesssignals.

Beispielsweise kann der Hallsensor zur Winkelbestimmung in elektrischen Drosselvorrichtungen und elektrischen Regelklappen, insbesondere in Drosselklappen eingesetzt werden. Ferner kann der Hallsensor zur Ermittlung einer Winkelposition eines Stellelements (GPA, general purpose actuator) für Ventile verwendet werden. Des Weiteren kann der Hallsensor in Fahrpedalmodulen (APM, accelerator pedal module) oder in Pedalwert-Gebern (PWG) zum Einsatz kommen.

Ferner kann der Hallsensor zur Ermittlung einer Drehrate eines Elektromotors, zur Ermittlung einer Drehfrequenz eines Rades in ABS-Anwendungen oder zur Messung eines Drehmomentes einer Torsionsstange in einer Lenksäule eines Kraftfahrzeugs verwendet werden.

Der Hallsensor kann als feldstärken- oder vorzugsweise als feldrichtungsabhängiger Hallsensor ausgeführt sein. Der Hallsensor weist Hallelemente auf. Werden diese von einem Storm durchflossen und von einem z.B. senkrecht dazu verlaufenden Magnetfeld durchsetzt, so liefern sie Messsignale, die einer Ausgangsspannung entsprechen, die proportional zum Produkt der magnetischen Feldstärke und des Strom sind.

Ferner kann der Hallsensor als Spinning-Current-Hall-Sensor ausgeführt sein. Dabei können jeweils mehrere Anschlüsse als Stromversorgung und mehrere Anschlüsse als Hallspannungsabnehmer dienen. Die Funktionen der Anschlüsse können reihum vertauscht werden. Durch eine entsprechende Auswertung der Messergebnisse kann eine Offsetspannung deutlich reduziert werden.

Die Hallelemente des Hallsensors sind zu Hallelement-Paaren zusammengefasst. Die Hallelement-Paare können jeweils zwei ggf. identische und einander gegenüberliegende Hallelemente aufweisen. Dabei können die Hallelemente eines Hallelement-Paars auf einer Verbindungslinie bzw. im 180°-Winkel angeordnet sein. Die Verbindungslienen der Hallelemente des ersten Hallelement-Paars und der Hallelemente des zweiten Hallelementpaars können sich kreuzen. Ferner kann die Verbindunglinie der Hallelemente des dritten Hallelement-Paars die Verbindungslinien der anderen Hallelement-Paare kreuzen.

Das Hallelement kann dabei ein stationäres Bauelement sein, welches fest mit den umgebenden Strukturen verbunden ist. Es kann die Drehwinkelposition eines Bauelements ermitteln. Hierzu kann am rotierenden Bauelement z.B. ein Dauermagnet mit einer vorgegebenen Magnetfeldrichtung fixiert sein. Bei Drehung des Bauelements und damit des Dauermagneten wird mit Hilfe des ersten Hallelement-Paars ein erstes Messsignal ermittelt, welches z.B. einem Sinus-Wert bzw. einem x-Wert der Magnetfeldrichtung entspricht. Mit Hilfe des zweiten Hallelement-Paars wird ein zweites Messsignal ermittelt welches z.B. einem Cosinus-Wert bzw. einem y-Wert der Magnetfeldrichtung entspricht. Das mit Hilfe des dritten Hallelement-Paars ermittelte dritte Messsignal kann z.B. ebenfalls einen Sinus- bzw. x-Wert der Magnetfeldrichtung darstellen und zum Vergleich mit dem ersten Messsignal herangezogen werden. Wenn kein Fremdmagnetfeld am Hallsensor vorhanden ist, so entspricht das erste Messsignal dem dritten Messsignal. Liegt jedoch ein Fremdmagnetfeld vor, so weicht das dritte Messsignal vom ersten Messsignal ab. Aus der Abweichung dieser Messsignale voneinander und aus der bekannten Position der einzelnen Hallelemente am Hallsensor kann die Einwirkung des Fremdmagnetfeldes ermittelt werden.

Auf diese Weise kann ein durch das Fremdmagnetfeld verursachter Fehler im Gesamtmesssignal berücksichtigt, d.h. z.B. mit Hilfe eines bestimmten Berechnungsalgorithmus heraus gerechnet bzw. kompensiert werden. Das Gesamtmesssignal entspricht dabei z.B. dem durch den Hallsensor zu ermittelnden Drehwinkel eines Bauelements.

Das Fremdmagnetfeld, auch als Störfeld bezeichnet, kann dabei z.B. durch eine in der Nähe des Hallsensors verlaufende stromführende Leitung verursacht werden. Die Magnetfeldrichtung des Fremdmagnetfeldes ist statisch, während die Feldstärke des Fremdmagnetfeldes variieren kann.

Gemäß einem Ausführungsbeispiel der Erfindung sind das erste, das zweite und das dritte Messsignal abhängig von der Magnetfeldrichtung des Sensormagneten. D.h. die Messsignale repräsentieren eine Orientierung des Sensor-Magnetfeldes.

Gemäß einem weiteren Ausführungsbeispiel der Erfindung weist der Hallsensor ein viertes Hallelement-Paar auf, das ausgeführt ist, ein viertes ggf. Magnetfeldrichtungs-abhängiges Messsignal bereitzustellen. Die Hallelemente des vierten Hallelement-Paars sind dabei jeweils zwischen Hallelementen des ersten Hallelement-Paars und des zweiten Hallelement-Paars angeordnet. Durch dieses weitere Hallelement-Paar kann die Einwirkung eines Fremdmagnetfeldes besser kompensiert werden. Für eine zusätzliche Verbesserung der Korrektur des Gesamtmesswertes kann das Hallelement beliebig viele weitere Hallelement-Paare aufweisen.

Insbesondere kann das vierte Messsignal z.B. ebenfalls einen Cosinus- bzw. y-Wert der Magnetfeldrichtung darstellen und zum Vergleich mit dem zweiten Messsignal herangezogen werden. Liegt kein Fremdmagnetfeld am Hallsensor vor, so entspricht das vierte Messsignal dem zweiten Messsignal. Liegt jedoch ein Fremdmagnetfeld vor, so weichen die Messsignale voneinander ab. Aus der Abweichung und aus der bekannten Position der einzelnen Hallelemente kann die Einwirkung des Fremdmagnetfeldes noch genauer ermittelt werden.

Gemäß einem weiteren Ausführungsbeispiel der Erfindung ist das erste Hallelement-Paar um 90° gegen das zweite Hallelement-Paar versetzt am Hallsensor angeordnet. Das dritte Hallelement-Paar ist ferner um 45° gegenüber dem ersten Hallelement-Paar versetzt angeordnet. Beispielsweise können die einzelnen Hallelemente auf dem Umfang eines Kreises angeordnet sein. Ferner kann das vierte Hallelement-Paar um -45° gegenüber dem ersten Hallelement-Paar versetzt angerordnet sein. D.h. das dritte und das vierte Hallelement-Paar sind um 90° gegeneinander versetzt. Die einzelnen Positionen der Hallelemente sind dabei bekannt.

Gemäß der Erfindung weist der Hallsensor ferner eine Messvorrichtung auf. Die Messvorrichtung ist dabei ausgeführt, das erste Messsignal, das zweite Messsignal, das dritte Messsignal und ggf. auch das vierte Messsignal zu ermitteln und derart zu einem Gesamtmesssignal zu kombinieren, dass im Gesamtmesssignal ein durch ein Fremdmagnetfeld verursachter Fehler minimiert ist.

Die Messvorrichtung kann dabei z.B. eine Mikroprozessoreinheit sein. Insbesondere kann die Messvorrichtung als Teil einer anwendungsspezifischen integrierten Schaltung (ASIC, application specific integrated circuit) ausgeführt sein. Die Messvorrichtung kann die Messsignale gleichzeitig ermitteln bzw. auslesen. Ferner kann die Messvorrichtung einen Berechnungsalgorithmus auf die ermittelten Messsignale anwenden, so dass beim resultierenden Gesamtmesssignal der durch das Fremdmagnetfeld verursachte Fahler minimiert ist. Beispielsweise kann der Berechnungsalgorithmus durch Additionen, Subtraktionen und Mittelwertbildungen zwischen dem ersten und dem dritten Messsignal einen Fremdmagnetfeld-freien Sinus-Messwert des zu ermittelnden Magnetfelds bestimmen. Entsprechend kann auch der Cosinus-Messwert anhand des zweiten und des vierten Messsignals ermittelt werden. Anschließend kann ein Arcus-Tangens gebildet werden, so dass das ausgegebene Gesamtmesssignal einen Drehwinkel des mit einem Permanentmagneten versehenen Bauteils repräsentiert.

Gemäß einem weiteren Ausführungsbeispiel der Erfindung ist der Hallsensor als Teil einer anwendungsspezifischen integrierten Schaltung ausgeführt. D.h. der Hallsensor kann in eine Leistungs- bzw. Steuerelektronik integriert sein.

Gemäß einem zweiten Aspekt der Erfindung wird ein Verfahren zur Herstellung eines oben beschriebenen Hallsensors vorgestellt. Das Verfahren weist die folgenden Schritte auf: Vorsehen eines ersten Hallelement-Paars, das ausgeführt ist, ein erstes Messsignal bereitzustellen; Vorsehen eines zweiten Hallelement-Paars, das ausgeführt ist, ein zweites Messsignal bereitzustellen; Vorsehen eines dritten Hallelement-Paars, das ausgeführt ist, ein drittes Messsignal bereitzustellen; Anordnen der Hallelemente des dritten Hallelement-Paars jeweils zwischen Hallelementen des ersten Hallelement-Paars und des zweiten Hallelement-Paars; Ausgestalten der Hallelement-Paare derart ansteuerbar, dass das erste Messsignal, das zweite Messsignal und das dritte Messsignal zu einem Gesamtmesssignal kombinierbar sind, welches einen durch ein Fremdmagnetfeld verursachten Fehler berücksichtigt.

Gemäß einem dritten Aspekt der Erfindung wird die Verwendung des oben beschriebenen Hallsensors zur Winkelmessung in einem Hybrid- oder in einem Elektrofahrzeug vorgestellt.

Weitere Merkmale und Vorteile der vorliegenden Erfindung werden dem Fachmann aus der nachfolgenden Beschreibung beispielhafter Ausführungsformen, die jedoch nicht als die Erfindung beschränkend auszulegen sind, unter Bezugnahme auf die beigelegten Zeichnungen ersichtlich.
- Fig. 1: zeigt eine Draufsicht auf ein bekanntes Hallelement
- Fig. 2: zeigt eine Draufsicht auf ein Hallelement mit vier Hallelement-Paaren gemäß einem Ausführungsbeispiel der Erfindung
- Fig. 3: zeigt das Hallelement aus Fig. 2 als Teil einer anwendungsspezifischen integrierten Schaltung
- Fig. 4: zeigt die Messsignale der einzelnen Hallelement-Paare des Hallsensors aus Fig. 2

Alle Figuren sind lediglich schematische Darstellungen erfindungsgemäßer Vorrichtungen bzw. ihrer Bestandteile gemäß Ausführungsbeispielen der Erfindung. Insbesondere Abstände und Größenrelationen sind in den Figuren nicht maßstabsgetreu wiedergegeben. In den verschiedenen Figuren sind sich entsprechende Elemente mit den gleichen Referenznummern versehen.

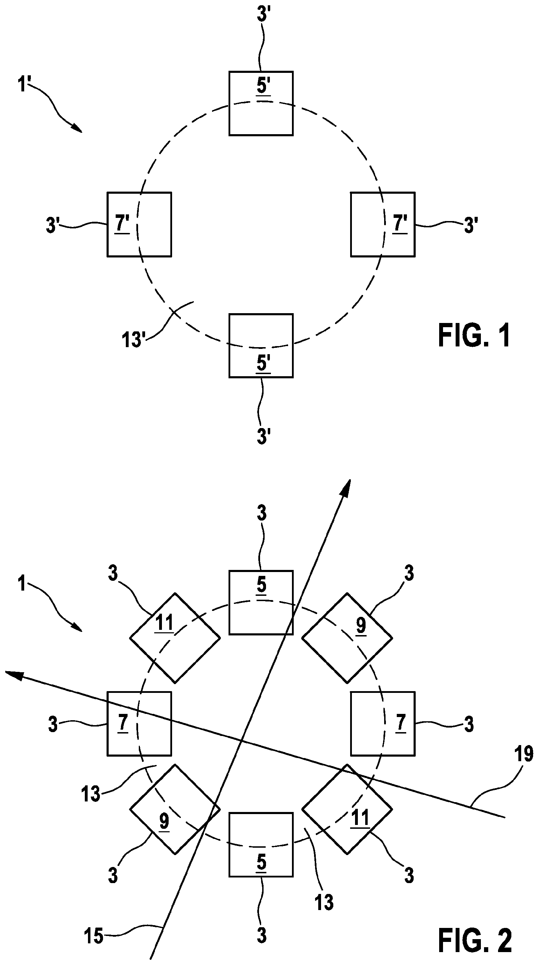

In Fig. 1 ist ein bekannter Hallsensor 1' gezeigt. Der Hallsensor 1' ist als Feldrichtungs-abhängiger Sensor ausgeführt und weist vier Hallelemente 3' auf, die auf einem Radius im Winkel von 90° angeordnet sind. Jeweils zwei gegenüberliegende Hallelemente 3' liefern zusammen ein Ausgangssignal bzw. eine Ausgangsspannung. Durch die Anordnung der Hallelemente 3' um 90° gegeneinander versetzt, ergibt sich ein Sinus- und ein Cosinussignal.

Die Messsignale der Hallelemente 3' sind von der Richtung des Magnetfeldes eines an einem Bauteil befestigten Permanentmagneten abhängig. Auf diese Weise kann die Winkelstellung des Permanentmagneten und damit des Bauteils, z.B. eines Ventils, ermittelt werden. Wegen der Abhängigkeit der Hallelemente 3' von der magnetischen Feldrichtung ist der Hallsensor 1' auf magnetische Stör- bzw. Fremdmagnetfelder 19 empfindlich. Ein Fremdmagnetfeld 19 kann z.B. durch eine in der Nähe des Hallsensors 1' verlaufende stromführende Leitung verursacht werden. Insbesondere können sich das stationäre Fremdmagnetfeld 19 und das Magnetfeld 15 des rotierenden Permanentmagneten wie in Fig. 2 gezeigt überlagern. Dies kann zu einer Verfälschung des Ausgabesignals des Hallsensors 1', also z.B. zu einer falschen Winkelangabe der Winkelposition des Bauteils mit Permanentmagnet, führen.

Der erfindungsgemäße Hallsensor 1, der anhand der Fig. 2 bis 4 näher erläutert wird, ist ausgeführt den Einfluss des Fremdmagnetfeldes 19 auf das Ausgabe- bzw. Gesamtmesssignal des Hallsensors 1 zu reduzieren.

Wie in Fig. 2 gezeigt weist der Hallsensor 1 ein erstes Hallelement-Paar 5 auf, das ausgeführt ist, ein erstes Messsignal 21 bereitzustellen. Ferner weist der Hallsensor 1 ein zweites Hallelement-Paar 7 auf, das ausgeführt ist, ein zweites Messsignal 23 bereitzustellen. Des Weiteren weist das Hallelement 1 ein drittes Hallelement-Paar 9 auf, das ausgeführt ist, ein drittes Messsignal 25 bereitzustellen. Schließlich weist das Hallelement 1 ein viertes Hallelement-Paar 11 auf, das ausgeführt ist, ein viertes Messsignal 27 bereitzustellen.

Die Hallelement-Paare 5, 7, 9, 11 weisen jeweils zwei einander gegenüber angeordnete Hallelemente 3 auf. Die Hallelemente 3 sind dabei auf einem z.B. kreisförmigen integrierten Flussleitstück 13 angeordnet. Das Flussleitstück 13 verstärkt die Magnetfelder im Bereich der Hallelemente 3.

Das erste Hallelement-Paar 5 ist gegenüber dem zweiten Hallelement-Paar 7 um 90° versetzt angeordnet. D.h. wenn sich ein Hallelement 3 des ersten Hallelement-Paars 5 bei 0° und das andere Hallelement 3 bei 180° befindet, so ist ein Hallelement 3 des zweiten Hallelement-Paars 7 bei 90° und das andere Hallelement 3 bei 270° angeordnet.

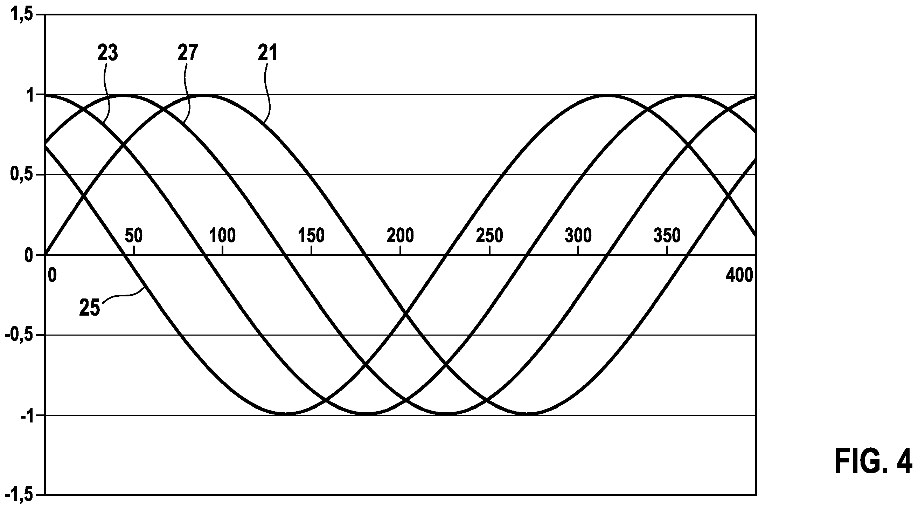

Das erste und das zweite Hallelement-Paar 5, 7 erzeugen dabei Hauptkennlinien. Z.B. erzeugt das erste Hallelement-Paar 5, wie in Fig. 4 dargestellt, ein Sinus-Signal, auch als erstes Messsignal 21 bezeichnet. Das zweite Hallelement-Paar 7 erzeugt ein Cosinus-Signal, auch als zweites Messsignal 23 bezeichnet. Durch das Fremdmagnetfeld 19 werden diese Kennlinien verzogen bzw. verzehrt und führen bei der Berechnung zu einer falschen Winkelangabe. Zur Reduzierung des Einflusses des Fremdmagnetfeldes 19 auf die berechnete Winkelangabe wird mindestens ein zusätzliches Hallelement-Paar verwendet. Im Ausführungsbeispiel in Fig. 2 sind zwei zusätzliche Hallelement-Paare 9, 11 vorgesehen. Die Hallelemente 3 dieser zusätzlichen Hallelement-Paare 9, 11 sind in den Zwischenräumen der ersten und zweiten Hallelement-Paare 5, 7 angeordnet.

Die Hallelemente 3 des dritten Hallelement-Paars 9 und des vierten Hallelement-Paars 11 sind jeweils zwischen den Hallelementen 3 des ersten und des zweiten Hallelement-Paars 5, 7 angeordnet. D.h. beispielsweise, dass ein Hallelement 3 des dritten Hallelement-Paars 9 bei 45° und das andere Hallelement 3 bei 225° angeordnet ist. Ferner ist ein Hallelement 3 des vierten Hallelement-Paars 11 bei 135° und das andere Hallelement dieses Hallelement-Paars 11 bei 315° angeordnet.

Die zwei zusätzlichen Hallelement-Paare 9, 11 ermöglichen es, jeweils ein weiteres Sinusförmiges- und ein weiteres Cosinusförmiges-Signal auszulesen. Das vom dritten Hallelement-Paar 9 bereitgestellte Sinusförmige-Signal wird auch als drittes Messsignal 25 bezeichnet. Das vom vierten Hallelement-Paar 11 bereitgestellte Cosinusförmige-Signal wird auch als viertes Messsignal 27 bezeichnet. Insgesamt liefert das Hallelement 1, wie in Fig. 4 dargestellt, zwei Sinusförmige- und zwei Cosinusförmige Kennlinien.

Die Hallelement-Paare 5, 7, 9, 11 sind derart ansteuerbar, dass das erste Messsignal 21, das zweite Messsignal 23, das dritte Messsignal 25 und ggf. das vierte Messsignal 27 zu einem Gesamtmesssignal kombinierbar sind, welches einen durch das Fremdmagnetfeld 19 verursachten Fehler berücksichtigt. D.h. bei der Berechnung des Gesamtmesssignals werden die einzelnen Messsignale 5, 7, 9, 11 z.B. mit Hilfe eines Berechnungsalgorithmus derart kombiniert bzw. verglichen, dass das Fremdmagnetfeld 19 keinen oder einen erheblich reduzierten Einfluss auf das Gesamtmesssignal hat. Dabei fließen die Kenntnis der Positionen der Hallelemente 3 bzw. der Hallelement-Paare 5, 7, 9, 11 in die Berechnung ein. Ferner wird bei der Berechnung berücksichtigt, dass das Fremdmagnetfeld 19 ein Magnetfeld ist, welches keine Richtungsänderung durchführt, während das Magnetfeld 15 des rotierenden Bauteils mit Permanentmagnet ein bewegtes Magnetfeld ist, welches eine Richtungsänderung erfährt. Beispielsweise kann das Gesamtmesssignal auf einer Summen- und ArcTangens-Bildung der Sinus- und Cosinus-Signale basieren.

Das berechnete Gesamtmesssignal ist somit relativ unempfindlich gegenüber Fremdmagnetfeldern 19. Dies kann insbesondere beim Einsatz des Hallsensors 1 in Hybrid- oder in Elektrofahrzeugen von Vorteil sein, da in diesen Fahrzeugen besonders viele elektrische Leitungen und Leistungselektroniken als Quellen für Fremdmagnetfelder 19 fungieren.

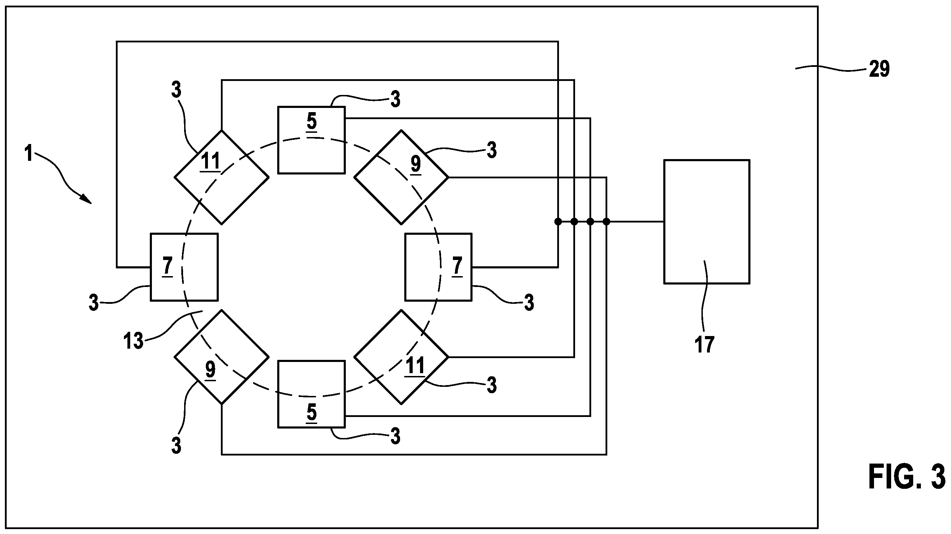

Fig. 3 zeigt ein Ausführungsbeispiel, bei dem der Hallsensor 1 als Teil einer ASIC 29 ausgeführt ist. Dabei kann eine ebenfalls in die ASIC 29 integrierte Messvorrichtung 17 die einzelnen Messsignale 21, 23, 25, 27 auslesen. Ferner kann ein Mikroprozessor, der ebenfalls als Teil der ASIC 29 ausgeführt sein kann, den Berechnungsalgorithmus ausführen und das Gesamtmesssignal ausgeben. Die Messvorrichtung 17 kann dabei in den Mikroprozessor integriert bzw. als Mikroprozessor ausgeführt sein.

In Fig. 4 sind die Messsignale 21, 23, 25, 27 der einzelnen Hallelement-Paare 5, 7, 9, 11 dargestellt. Dabei ist auf der x-Achse ein Winkel in ° und auf der y-Achse die Hallspannung in V aufgetragen.

Abschließend wird angemerkt, dass Ausdrücke wie "aufweisend" oder ähnliche nicht ausschließen sollen, dass weitere Elemente oder Schritte vorgesehen sein können. Des Weiteren sei darauf hingewiesen, dass "eine" oder "ein" keine Vielzahl ausschließen. Außerdem können in Verbindung mit den verschiedenen Ausführungsformen beschriebene Merkmale beliebig miteinander kombiniert werden. Es wird ferner angemerkt, dass die Bezugszeichen in den Ansprüchen nicht als den Umfang der Ansprüche beschränkend ausgelegt werden sollen.

## Patentansprüche

1. Hallsensor (1), der Hallsensor (1) aufweisend
ein erstes Hallelement-Paar (5), das ausgeführt ist, ein erstes Messsignal (21) bereitzustellen;
ein zweites Hallelement-Paar (7), das ausgeführt ist, ein zweites Messsignal (23) bereitzustellen;
wobei der Hallsensor (1) ferner ein drittes Hallelement-Paar (9) aufweist, das ausgeführt ist, ein drittes Messsignal (25) bereitzustellen;
wobei die Hallelemente (3) des dritten Hallelement-Paars (9) jeweils zwischen Hallelementen (3) des ersten Hallelement-Paars (5) und des zweiten Hallelement-Paars (7) angeordnet sind; **dadurch gekennzeichnet, dass** die Hallelement-Paare (5, 7, 9) derart ansteuerbar sind, dass das erste Messsignal (21), das zweite Messsignal (23) und das dritte Messsignal (25) zu einem Gesamtmesssignal kombinierbar sind, welches einen durch ein Fremdmagnetfeld (19) verursachten Fehler kompensiert,
wobei der Hallsensor eine Messvorrichtung aufweist, die ausgeführt ist, zumindest das erste Messsignal, das zweite Messsignal und das dritte Messsignal zu ermitteln und derart zu einem Gesamtmesssignal zu kombinieren, dass im Gesamtmesssignal ein durch ein Fremdmagnetfeld verursachter Fehler minimiert ist,
wobei die Messvorrichtung dazu ausgebildet ist, die Messsignale gleichzeitig zu ermitteln.

2. Hallsensor (1) gemäß Anspruch 1,
wobei das erste Messsignal (21), das zweite Messsignal (23) und das dritte Messsignal (25) Magnetfeldrichtungs-abhängige Signale sind.

3. Hallsensor (1) gemäß einem der Ansprüche 1 und 2, ferner aufweisend ein viertes Hallelement-Paar (11), das ausgeführt ist, ein viertes Messsignal (27) bereitzustellen;
wobei die Hallelemente (3) des vierten Hallelement-Paars (11) jeweils zwischen Hallelementen (3) des ersten Hallelement-Paars (5) und des zweiten Hallelement-Paars (7) angeordnet sind.

4. Hallsensor (1) gemäß einem der Ansprüche 1 bis 3,
wobei die Hallelement-Paare (5, 7, 9, 11) derart angeordnet sind, dass das jedes der vier Messsignale (21, 23, 25, 27) zur Kompensation eines der drei anderen Messsignale verwendet werden kann.

5. Hallsensor (1) gemäß einem der Ansprüche 1 bis 4,
wobei das erste Hallelement-Paar (5) um 90° gegen das zweite Hallelement-Paar (7) versetzt ist;
wobei das dritte Hallelement-Paar (9) um 45° gegenüber dem ersten Hallelement-Paar (5) versetzt ist.

6. Hallsensor (1) gemäß einem der Ansprüche 1 bis 5, ferner aufweisend eine Messvorrichtung (17), die ausgeführt ist, das erste Messsignal (21), das zweite Messsignal (23) und das dritte Messsignal (25) zu ermitteln und derart zu einem Gesamtmesssignal zu kombinieren, dass im Gesamtmesssignal ein durch das Fremdmagnetfeld (19) verursachter Fehler minimiert ist.

7. Hallsensor (1) gemäß einem der Ansprüche 1 bis 6,
wobei der Hallsensor (1) als Teil einer anwendungsspezifischen integrierten Schaltung (29) ausgeführt ist.

8. Verfahren zur Herstellung eines Hallsensors (1) gemäß einem der Ansprüche 1 bis 7, das Verfahren aufweisend die folgenden Schritte Vorsehen eines ersten Hallelement-Paars (5), das ausgeführt ist, ein erstes Messsignal (21) bereitzustellen;
Vorsehen eines zweiten Hallelement-Paars (7), das ausgeführt ist, ein zweites Messsignal (23) bereitzustellen;
das Verfahren **gekennzeichnet dadurch, dass** es ferner aufweist Vorsehen eines dritten Hallelement-Paars (9), das ausgeführt ist, ein drittes Messsignal (25) bereitzustellen;
Anordnen der Hallelemente (3) des dritten Hallelement-Paars (9) jeweils zwischen Hallelementen (3) des ersten Hallelement-Paars (5) und des zweiten Hallelement-Paars (7);
Ausgestalten der Hallelement-Paare (5, 7, 9) derart ansteuerbar, dass das erste Messsignal (21), das zweite Messsignal (23) und das dritte Messsignal (25) zu einem Gesamtmesssignal kombinierbar sind, welches einen durch ein Fremdmagnetfeld (19) verursachten Fehler berücksichtigt,
Vorsehen einer Messvorrichtung, die ausgeführt ist, zumindest das erste Messsignal, das zweite Messsignal und das dritte Messsignal zu ermitteln und derart zu einem Gesamtmesssignal zu kombinieren, dass im Gesamtmesssignal ein durch ein Fremdmagnetfeld verursachter Fehler minimiert ist, wobei die Messvorrichtung dazu ausgebildet ist, die Messsignale gleichzeitig zu ermitteln.

9. Verwendung eines Hallsensors (1) gemäß einem der Ansprüche 1 bis 7 zur Winkelmessung in Kraftfahrzeugen.

## Claims

1. Hall sensor (1), the Hall sensor (1) comprising a first Hall element pair (5) that is implemented to provide a first measurement signal (21);
a second Hall element pair (7) that is implemented to provide a second measurement signal (23);
wherein the Hall sensor (1) also comprises a third Hall element pair (9) that is implemented to provide a third measurement signal (25);
wherein the Hall elements (3) of the third Hall element pair (9) are each disposed between Hall elements (3) of the first Hall element pair (5) and of the second Hall element pair (7);
**characterized in that** the Hall element pairs (5, 7, 9) can be activated such that the first measurement signal (21), the second measurement signal (23) and the third measurement signal (25) can be combined to form a total measurement signal that compensates for errors caused by an external magnetic field (19), wherein the Hall sensor comprises a measuring device that is implemented to determine at least the first measurement signal, the second measurement signal and the third measurement signal and to combine the same to form a total measurement signal, such that an error caused by an external magnetic field is minimized in the total measurement signal, wherein the measuring device is designed to determine the measurement signals simultaneously.

2. Hall sensor (1) according to Claim 1,
wherein the first measurement signal (21), the second measurement signal (23) and the third measurement signal (25) are magnetic field direction dependent signals.

3. Hall sensor (1) according to any one of Claims 1 and 2, further comprising a fourth Hall element pair (11) that is implemented to provide a fourth measurement signal (27);
wherein the Hall elements (3) of the fourth Hall element pair (11) are each disposed between Hall elements (3) of the first Hall element pair (5) and of the second Hall element pair (7).

4. Hall sensor (1) according to any one of Claims 1 to 3,
wherein the Hall element pairs (5, 7, 9, 11) are disposed such that each of the four measurement signals (21, 23, 25, 27) can be used for compensation of one of the other three measurement signals.

5. Hall sensor (1) according to any one of Claims 1 to 4,
wherein the first Hall element pair (5) is offset by 90° relative to the second Hall element pair (7);
wherein the third Hall element pair (9) is offset by 45° relative to the first Hall element pair (5).

6. Hall sensor (1) according to any one of Claims 1 to 5, further comprising a measuring device (17) that is implemented to determine the first measurement signal (21), the second measurement signal (23) and the third measurement signal (25) and to combine the same to form a total measurement signal, such that an error caused by the external magnetic field (19) is minimized in the total measurement signal.

7. Hall sensor (1) according to any one of Claims 1 to 6, wherein the Hall sensor (1) is implemented as part of an application specific integrated circuit (29).

8. Method for manufacturing a Hall sensor (1) according to any one of Claims 1 to 7, the method comprising the following steps
providing a first Hall element pair (5) that is implemented to provide a first measurement signal (21); providing a second Hall element pair (7) that is implemented to provide a second measurement signal (23); the method **characterized in that** it further comprises providing a third Hall element pair (9) that is implemented to provide a third measurement signal (25); disposing each Hall element (3) of the third Hall element pair (9) between Hall elements (3) of the first Hall element pair (5) and of the second Hall element pair (7); configuring the Hall element pairs (5, 7, 9) to be able to be activated such that the first measurement signal (21), the second measurement signal (23) and the third measurement signal (25) can be combined to form a total measurement signal that takes into account an error caused by an external magnetic field (19),
providing a measuring device that is implemented to determine at least the first measurement signal, the second measurement signal and the third measurement signal and to combine the same to form a total measurement signal, such that an error caused by an external magnetic field is minimized in the total measurement signal, wherein the measuring device is designed to determine the measurement signals simultaneously.

9. Use of a Hall sensor (1) according to any one of Claims 1 to 7 for angle measurement in motor vehicles.

## Revendications

1. Capteur à effet Hall (1), le capteur à effet Hall (1) comprenant
une première paire d'éléments à effet Hall (5) qui est conçue pour délivrer un premier signal de mesure (21) ; une deuxième paire d'éléments à effet Hall (7) qui est conçue pour délivrer un deuxième signal de mesure (23) ; le capteur à effet Hall (1) comprenant en outre une troisième paire d'éléments à effet Hall (9) qui est conçue pour délivrer un troisième signal de mesure (25) ; les éléments à effet Hall (3) de la troisième paire d'éléments à effet Hall (9) étant respectivement disposés entre les éléments à effet Hall (3) de la première paire d'éléments à effet Hall (5) et la deuxième paire d'éléments à effet Hall (7) ;
**caractérisé en ce que**
les paires d'éléments à effet Hall (5, 7, 9) peuvent être excitées de telle sorte que le premier signal de mesure (21), le deuxième signal de mesure (23) et le troisième signal de mesure (25) peuvent être combinés en un signal de mesure total qui compense une erreur provoquée par un champ magnétique externe (19),
le capteur à effet Hall possédant un dispositif de mesure qui est conçu pour déterminer au moins le premier signal de mesure, le deuxième signal de mesure et le troisième signal de mesure et les combiner en un signal de mesure total de telle sorte qu'une erreur provoquée par un champ magnétique externe est réduite au minimum dans le signal de mesure total,
le dispositif de mesure étant conçu pour déterminer les signaux de mesure simultanément.

2. Capteur à effet Hall (1) selon la revendication 1, le premier signal de mesure (21), le deuxième signal de mesure (23) et le troisième signal de mesure (25) étant des signaux dépendants de la direction du champ magnétique.

3. Capteur à effet Hall (1) selon l'une des revendications 1 et 2, comprenant en outre une quatrième paire d'éléments à effet Hall (11) qui est conçue pour délivrer un quatrième signal de mesure (27) ;
les éléments à effet Hall (3) de la quatrième paire d'éléments à effet Hall (11) étant respectivement disposés entre les éléments à effet Hall (3) de la première paire d'éléments à effet Hall (5) et de la deuxième paire d'éléments à effet Hall (7).

4. Capteur à effet Hall (1) selon l'une des revendications 1 à 3, les paires d'éléments à effet Hall (5, 7, 9, 11) étant disposées de telle sorte que chacun des quatre signaux de mesure (21, 23, 25, 27) peut être utilisé pour la compensation de l'un des trois autres signaux de mesure.

5. Capteur à effet Hall (1) selon l'une des revendications 1 à 4, la première paire d'éléments à effet Hall (5) étant décalée de 90° par rapport à la deuxième paire d'éléments à effet Hall (7) ;
la troisième paire d'éléments à effet Hall (9) étant décalée de 45° par rapport à la première paire d'éléments à effet Hall (5).

6. Capteur à effet Hall (1) selon l'une des revendications 1 à 5, possédant en outre un dispositif de mesure (17) qui est conçu pour déterminer le premier signal de mesure (21), le deuxième signal de mesure (23) et le troisième signal de mesure (25) et les combiner en un signal de mesure total de telle sorte qu'une erreur provoquée par le champ magnétique externe (19) est réduite au minimum dans le signal de mesure total.

7. Capteur à effet Hall (1) selon l'une des revendications 1 à 6, le capteur à effet Hall (1) étant réalisé en tant que partie d'un circuit intégré à application spécifique (29).

8. Procédé de fabrication d'un capteur à effet Hall (1) selon l'une des revendications 1 à 7, le procédé comprenant les étapes suivantes :
fourniture d'une première paire d'éléments à effet Hall (5) qui est conçue pour délivrer un premier signal de mesure (21) ;
fourniture d'une deuxième paire d'éléments à effet Hall (7) qui est conçue pour délivrer un deuxième signal de mesure (23) ;
le procédé étant **caractérisé en ce qu'**il comprend en outre
fourniture d'une troisième paire d'éléments à effet Hall (9) qui est conçue pour délivrer un troisième signal de mesure (25) ;
disposition des éléments à effet Hall (3) de la troisième paire d'éléments à effet Hall (9) respectivement entre les éléments à effet Hall (3) de la première paire d'éléments à effet Hall (5) et la deuxième paire d'éléments à effet Hall (7) ;
configuration des paires d'éléments à effet Hall (5, 7, 9) excitables de telle sorte que le premier signal de mesure (21), le deuxième signal de mesure (23) et le troisième signal de mesure (25) peuvent être combinés en un signal de mesure total qui tient compte d'une erreur provoquée par un champ magnétique externe (19),
fourniture d'un dispositif de mesure qui est conçu pour déterminer au moins le premier signal de mesure, le deuxième signal de mesure et le troisième signal de mesure et les combiner en un signal de mesure total de telle sorte qu'une erreur provoquée par un champ magnétique externe est réduite au minimum dans le signal de mesure total, le dispositif de mesure étant conçu pour déterminer les signaux de mesure simultanément.

9. Utilisation d'un capteur à effet Hall (1) selon l'une des revendications 1 à 7 pour la mesure d'angle dans les véhicules automobiles.
